# EUROPEAN PATENT APPLICATION

(11) **EP 2 217 046 A2**
(43) Date of publication of application: **11.08.2010**
(21) Application number: 10445002.8
(22) Date of filing: 08.02.2010
(51) Int. Cl.: H05K 5/02

(54) **Box for an electrical installation**

(30) Priority: 10.02.2009 SE 0900157
(71) Applicant: Digisign AB, 126 30 Hägersten (SE)
(72) Inventor: Wirgart, Bengt, SE-117 61 Stockholm (SE)
(74) Representative: Eriksson, Kjell

(57) **Abstract**

The present invention relates to a box for an electrical installation, such that the box comprises a cover (1) and a plate (3), the cover (1) can be fitted to/removed from the plate (3), the cover comprises four walls (11,12) situated in pairs opposite one another, mutually facing bulges (15) are provided on two opposite walls (11), the plate (3) is intended to be mounted on a substrate, and recesses (7) are provided in two opposite side edges of the plate (3).

The box according to the present invention is distinguished in that the plate (3) is provided with chamfers (9) in the region of its corners and that the opposite sidewalls (11) of the cover (1) which are provided with bulges (15) have portions (16) of reduced thickness.

## Description

### Technical field of the invention

The present invention relates to a box for an electrical installation, which box comprises a cover with four walls situated in pairs opposite to one another, mutually facing tongues disposed on two opposite walls, a plate intended to be mounted on a substrate, and recesses disposed on two opposite side edges of the plate.

### State of the art

An electrical box for surface mounting which is known from US 5,195,901 comprises a cover which on the edges of two opposite walls has tongues which extend towards one another. These tongues are intended to engage in slits/grooves in a plate which forms part of the box and is mounted on a wall. Fingerholes are provided on the outside of the cover, close to the tongues. When the cover is to be removed from the plate, the operator inserts a finger of each hand into the fingerholes before using his/her thumbs to press on the front wall of the cover. The result is that the opposite walls of the cover which are provided with tongues bend outwards and the engagement of the tongues with the slits/grooves ceases.

### Objects and features of the invention

A primary object of the present invention is to propose a box of the kind defined in the introduction which enables an authorised person to remove in an extremely easy and user-friendly manner the cover which forms part of the box.

Another object of the present invention is that it should in principle be impossible for an unauthorised person to remove the cover which forms part of the box.

A further object of the present invention is that an authorised person should with one hand be able to remove the cover which forms part of the box.

Yet another object of the present invention is that an authorised person should be able to remove the cover without using any tool.

At least the primary object of the present invention is achieved by a device which has the features indicated in the independent claim 1 set out below. Preferred embodiments of the invention are defined in the dependent claims.

### Brief description of the drawings

A preferred embodiment of the invention is described below with reference to the attached drawings, in which:
- Fig. 1: depicts an exploded view of a box according to the present invention, as seen when looking at the outside of a cover which forms part of the box and at the outside of a mounting plate which forms part of the box according to the present invention;
- Fig. 2: depicts a perspective view of the cover which forms part of the box according to the present invention, as seen when looking at the internal space of the cover; and
- Fig. 3: depicts a front view of the box according to the present invention, illustrating deformation of the cover by forces applied in opposite directions.

### Detailed description of a preferred embodiment of the invention

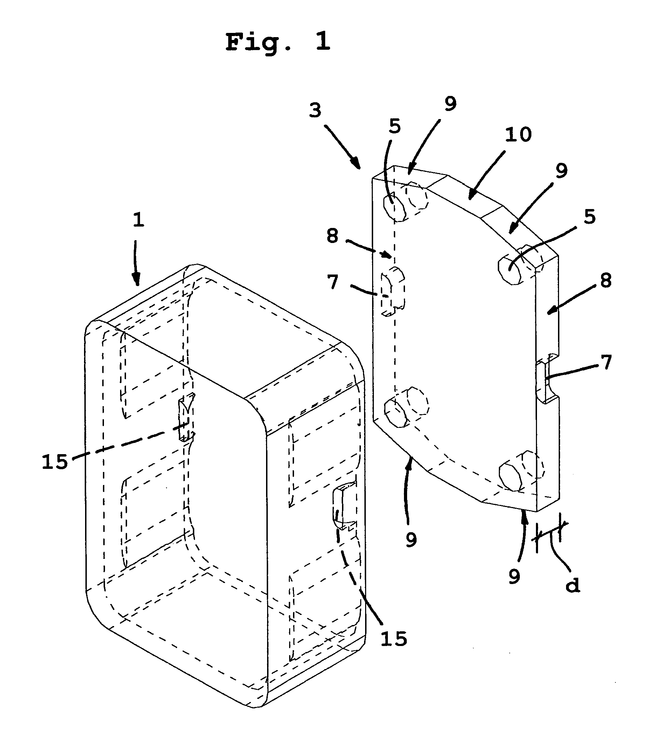

The box depicted in Fig. 1 according to the present invention comprises a cover 1 and a mounting plate 3, which are of generally rectangular shape as seen in plan view. The mounting plate 3 is intended to be mounted on a substrate, e.g. a wall. To this end, the mounting plate 3 is provided, in the region of its corners, with four holes 5 intended to accommodate suitable fastening means (not depicted).

The mounting plate 3 has a certain thickness, symbolised by the measure "d" in Fig. 1. The mounting plate 3 is provided with two recesses 7 on two opposite first side edges 8. The mounting plate 3 has four first chamfers 9 in the area of its corner regions. In the embodiment depicted, the first chamfers 9 are situated on the shorter second side edges 10 of the mounting plate 3. The first chamfers 9 result in the mounting plate 3 having a shape which differs somewhat from geometrically rectangular.

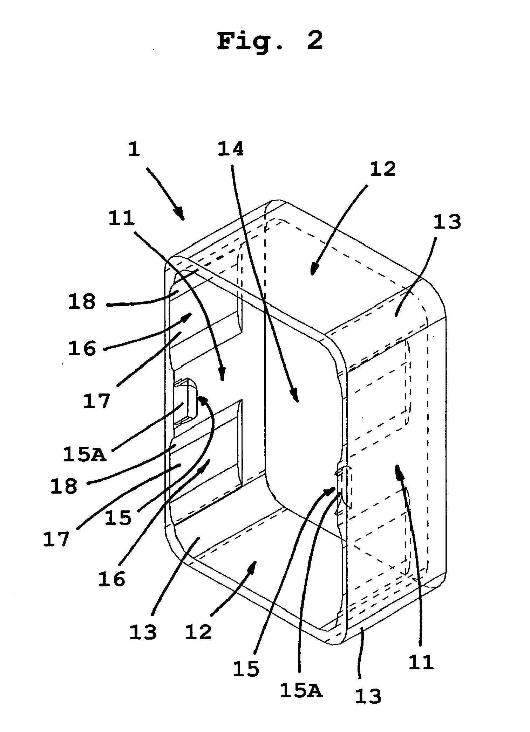

The cover 1 which forms part of the box according to the present invention is depicted in both Fig. 1 and Fig. 2. The cover 1 comprises four sidewalls 11, 12 situated in pairs opposite one another. In the embodiment depicted, the cover 1 has gently rounded first transition portions 13 between adjoining sidewalls 11, 12. The cover 1 comprises also a front wall 14 which connects to the four sidewalls 11, 12.
The edges of the sidewalls 11, 12 which point away from the front wall 14 define an aperture of the cover 1.

The two opposite first walls 11 have means protruding towards one another in the form of bulges 15 situated close to the aperture of the cover 1. The bulges 15 are opposite to one another. As depicted in Fig. 2, the bulges 15 are provided with second chamfers 15A on their side which faces away from the internal space of the cover 1. The portion of the second chamfers 15A which is situated at the free ends of the bulges 15 is nearer to the front wall 14 than the portion of the chamfers 15A which is situated at the connection of the bulges 15 to the first sidewalls 11.

Each of the two opposite first sidewalls 11 comprises also portions of reduced wall thickness, which portions according to the embodiment described take the form of two bays 16 which each comprise a bottom portion 17 and two second transition portions 18 which connect to the adjoining portions of the first sidewalls 11. The second transition portions 18 are gently rounded. As may be seen most clearly in Fig. 2, the first sidewalls 11 are provided with reduced thickness in the regions of the bays 16. Figs. 1 and 2 also show that on each of the first sidewalls 11 the bulges 15 are situated between the bays 16.

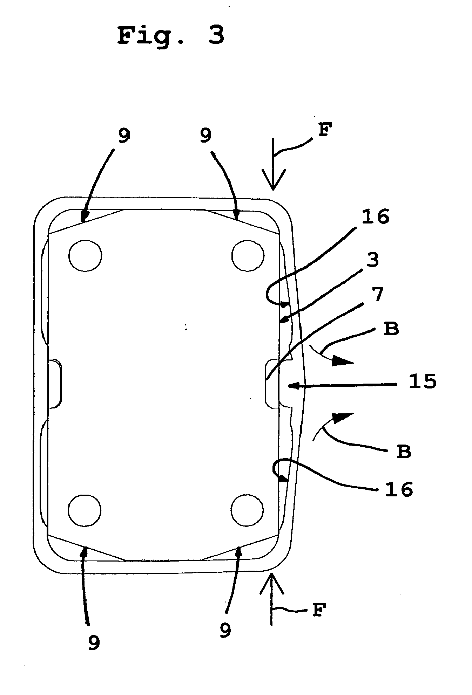

Fig. 3 depicts schematically how the cover of the box according to the present invention becomes deformed when the cover 1 is being fitted to/removed from the mounting plate 3. In this context it should be noted that the recesses 7 and the bulges 15 are so placed relative to one another that they can be brought into mutual engagement when the cover 1 is fitted on the mounting plate 3.

The arrows pointing in opposite directions and marked "F" symbolise the forces in opposite directions which the user applies to the cover 1 when removing it from the mounting plate 3. As depicted in Fig. 3, deformation of the cover 1 will occur when the opposing forces F are applied. In this context it should be noted that the opposing forces F depicted in Fig. 3 may be applied by the user with one hand, using with advantage the forefinger and thumb of the same hand.

Examination of Fig. 3 will show that the presence of the chamfers 9 on the mounting plate 3 means that the corner regions of the cover 1 where the opposing forces F are applied can be moved towards one another. This movement of the corner regions results in the first sidewall 11 bending outwards in the region of its middle portion, i.e. the portion which bears the bulge 15. The outward bending is represented by the arrows B in Fig. 3. As depicted in Fig. 3, the outward bending B of the first sidewall 11 can proceed so far that the engagement between the bulge 15 and the recess 7 ceases. In this context it should be noted that the bays 16 provided in the first sidewall 11 make this outward bending possible by the weakening of the first sidewall 11 which is caused by the bays 16. The state of the cover 1 depicted in Fig. 3, i.e. with a first sidewall 11 bent outwards, is used for removing the cover 1 from the mounting plate 3. The fact that the bulge 15 on one side loses its engagement with the relating recess 7 makes it possible for one side of the cover 1 to be angled away from the mounting plate 3. Thereafter the engagement between the second bulge 15 and the relating recess 7 can also be ended.

To fit the cover 1 to the mounting plate 3, the cover 1 is pressed against the mounting plate 3, resulting in the second chamfers 15A causing the bulges and a central portion of the first sidewalls 11 to bend outwards. The bulges 15 will thereafter "click" into the recesses 7.

It should be noted that it is extremely important that the cover 1 be made of entirely flexible material so that it reverts to its original shape after the deformation which it undergoes when being removed/fitted.

### Conceivable modifications of the invention

The respective shapes of the recesses 7 and bulges 15 referred to in the embodiment example described above are merely examples. The shapes of these components may vary in many ways but have to be mutually appropriate such that there is full cooperation between the recesses 7 and the bulges 15.

In the embodiment example referred to above, the front wall 14 of the cover 1 is plain. Within the scope of the present invention, however, it is conceivable that the front wall be configured in a number of different ways, e.g. it may be provided with one or more bosses.

In the embodiment described, the cover has bays 16 in both of the opposite first sidewalls 11. Within the scope of the present invention, however, it is conceivable that bays 16 be provided in the one first sidewall 11 only. In such an embodiment, fitting the cover will be effected in some other way than as described above. The sidewall which has no bays will not spring out but the bulge pertaining to that sidewall will be applied first in its corresponding recess before the bulge on the second sidewall, the sidewall provided with bays, is pressed against the mounting plate. The result is that the sidewall will bend outwards as described above.

## Claims

1. A box for an electrical installation, such that the box comprises a cover (1) and a plate (3), the cover (1) can be fitted to/removed from the plate (3), the cover comprises four walls (11,12) situated in pairs opposite one another, mutually facing bulges (15) are provided on two opposite walls (11), the plate (3) is intended to be mounted on a substrate, and recesses (7) are provided in two opposite side edges of the plate (3), **characterised in that** the plate (3) is provided with chamfers (9) in the region of at least two neighbouring corners and that at least one of the opposite sidewalls (11) of the cover (1), which sidewalls (11) are provided with bulges (15), has portions (16) of reduced thickness.

2. A box according to claim 1, **characterised in that** the plate (3) is provided with chamfers (9) in the region of all of the corners and that both of the sidewalls (11) provided with bulges (15) have portions (16) of reduced thickness.

3. A box according to claim 1 or 2, **characterised in that** the portions of reduced thickness take the form of bays (16).

4. A box according to any one of the above claims, **characterised in that** each opposite sidewall (11) is provided with two portions (16) of reduced thickness.

5. A box according to claim 4, **characterised in that** the bulge (15) is situated between the portions (16) of reduced thickness.

6. A box according to any one of the above claims, **characterised in that** the chamfers take the form of planar portions (9).

7. A box according to any one of the above claims, **characterised in that** the bulges (15) are provided with chamfers (15A) on the side which faces away from the internal space of the cover (1).
